Europäisches Patentamt

European Patent Office

Office européen des brevets

(11) Publication number: **0 323 239**
**A2**

# EUROPEAN PATENT APPLICATION

(21) Application number: 88312374.7

(22) Date of filing: 28.12.88

(51) Int. Cl.⁴: **H 01 L 39/22**

(30) Priority: 25.12.87 JP 328879/87

(43) Date of publication of application:
05.07.89 Bulletin 89/27

(84) Designated Contracting States: **DE FR GB**

(71) Applicant: CHICHIBU CEMENT CO., LTD.
c/o Nihon Kogyo Kurabu 1-4-6, Marunochi Chiyoda-ku
Tokyo 100 (JP)

(72) Inventor: Akihama, Ryozo c/o Chichibu Co. Ltd.
Kaihatsu Honbu 5310, Oaza-Mikajiri
Kumagaya-shi Saitama 360 (JP)

(74) Representative: Deans, Michael John Percy et al
Lloyd Wise, Tregear & CO. Norman House 105-109 Strand
London WC2R OAE (GB)

(54) Oxide superconductors.

(57) An oxide superconductor has a thin layer of a normally conductive material interposed between and joining oxide superconductor crystallites together. The normally conductive material is sufficiently thin to be rendered effectively superconductive by a tunnel effect.

EP 0 323 239 A2

Bundesdruckerei Berlin

## Description

### OXIDE SUPERCONDUCTORS

The present invention relates to oxide superconductors.

It has been known for long that as some metals or alloys are cooled to the vicinity of absolute zero, their electrical resistance is reduced to zero, and recent reports have revealed that oxides of the perovskite structure show such superconductivity.

The superconductivity of such oxides cannot be used for any practical conductor because of their critical current density being extremely low.

These oxides of the perovskite structure have a transition temperature higher than the boiling point of nitrogen, and are called "high-temperature oxide superconductors". In view of their relatively high transition temperature, they are now under study to put them to practical use.

Since such high-temperature oxide superconductors are of a generally layered structure, however, large anisotropies appear in critical magnetic field Hc and critical current Jc. In thin-film single crystals, a limitation is placed on the direction of current flow.

In an aggregate of single crystals, the junctions between single crystals have such random directionality that a barrier to current flow is set up. In a polycrystal thin-film, on the other hand, no satisfactory superconductive contact is achieved on the interfaces of single crystals.

In addition, when oxide superconductors are formed into a wire or shield configuration, only a very limited superconductive contact area is obtained, since these configurations are sintered bodies and, hence, are of microporosity.

The present invention has resulted from work seeking to solve the above problems, and to provide an oxide superconductor having satisfactory superconductivity in spite of being of a layer structure.

Oxide superconductors in accordance with the present invention seek effectively to maintain superconduction at the junctions of the interfaces of superconductor polycrystals thereof at a level comparable with that achieved in oxide superconductor single crystals, and are characterized in that a thin layer of a normally conductive metal is interposed between and joins oxide superconductor crystallites together, said normally conductive metal being made sufficiently thin effectively to be rendered superconductive by the tunnel effect.

As said normally conductive metals, use may be made of gold Au, platinum Pt, silver Ag, aluminium Al, copper Cu, nickel Ni, indium In, tin Sn, lead Pb, titanium Ti, vanadium V, zirconium Zr, niobium Nb, hafnium Hf, tantalum Ta, tungsten W, molybdenum Mo and mercury Hg, each permitting easy leakage of the wave function of a superconductor, or an alloy of two or more of said elements.

It is to be noted that use may also be made of a compound easily convertible into silver, Au, etc. by intermediate firing such as, for instance, silver oxide ($Ag_2O$).

It is also to be understood that the thickness of the normally conductive metal layer may be determined based on the length of coherence due to the tunnel effect.

In order to prepare such an oxide superconductor, oxide superconductor powders are mixed with powders of a normally conductive metal as mentioned above, and the mixture is filled into a sheath material formed of a normally conductive metal material, extruded therethrough, rolled, swaged and finally drawn into a fine wire.

The invention is hereinafter more particularly described by way of example only.

First of all, 10 % by volume of the total of a powder of a normally conductive metal (in this case Au (gold)) was mixed with superconductor powder of oxides of Y-Ba-Cu-O. In this case, the Au powders had a particle size of 10 μm. The thus obtained mixture was put in a tube of Ag (silver) and subjected to wire drawing selected to achieve a desired thickness of the normally conductive layer between superconductor crystallites in the finished wire. Then, critical current values Jc were found at a temperature of 77°K.

As a result, we have found that about 300 $A/cm^2$ was obtained when the thickness of the normally conductive layer Au was about 10,000 to 5,000 Angstroms, but 6,000 $A/cm^2$ were reached at less than 2,000 Angstroms and as high as about 80,000 $A/cm^2$ were reached at less than 1,000 Angstroms due to the tunnel effect becoming significant.

We have found such composite materials in which a noticeable tunnel effect is present to have a critical current value up to 100 times as large as that of a fine wire formed only of superconductor polycrystals based on the oxides of Y-Ba-Cu-O.

The critical current Jc of superconductors appears to be improved at the junctions of the single crystal interfaces of a single crystal aggregate of anisotrophy for the reason that, if the thickness of the normally conductive metal layer is made substantially equal to the length of coherence, then leakage of the superconduction wave function into the normally conductive metal is facilitated by the tunnel effect, resulting in superconduction.

We have found that, not only is it possible to achieve substantial improvements in the value of the critical current Jc in an oxide superconductor that is a polycrystal anisotropic aggregate, but that steps such as wire drawing are facilitated by the lubrication of the added normally conductive metal such as Au.

### Claims

1. An oxide superconductor characterised in that a thin layer of a normally conductive material is interposed between and joins superconductor crystallites together, said normally conductive material sufficiently thin effectively to be rendered superconductive by a tunnel effect.

2. An oxide superconductor as claimed in Claim 1, further characterised in that said normally conductive material is a metal.

3. An oxide superconductor as claimed in Claim 1 or 2, further characterised in that the thickness of said normally conductive material is equal to or less than the length of coherence due to the tunnel effect.